# EUROPEAN PATENT APPLICATION

(11) **EP 4 800 151 A1**
(43) Date of publication of application: **02.09.2026**
(21) Application number: 25187588.6
(22) Date of filing: 04.07.2025
(51) Int. Cl.: C23C 14/04, C23C 14/18, C30B 23/02, C30B 23/08, H10W 20/00, H10W 70/692

(54) **METHOD FOR DEPOSITING COPPER THIN FILM IN THROUGH GLASS VIA USING ATOMIC SPUTTERING EPITAXY**

(30) Priority: 26.02.2025 KR 20250024989
(71) Applicant: CIT Co., Ltd., Busan 46285 (KR)
(72) Inventor: Jeong, Seung, 08725 Seoul (KR); Jeong, Se Young, 48119 Busan (KR); Lee, You Sil, 47756 Busan (KR)
(74) Representative: Gulde & Partner

(57) **Abstract**

The present invention relates to electronic packaging and semiconductor process technology utilizing through glass via (TGV) technology, and to a method for improving electrical characteristics through more reliable copper (Cu) thin film deposition.

The method of depositing a copper thin film inside a TGV using atomic layer sputtering epitaxy (ASE) is characterized in that the copper thin film is homogeneously deposited on the inside and surface of the TGV using an ASE process, and the copper thin film is deposited so that the upper and lower electrical resistances of the TGV are less than or equal to 0.1 Ω.

## Description

### BACKGROUND OF THE INVENTION

### FIELD OF THE INVENTION

The present invention relates to electronic packaging and semiconductor process technology utilizing through glass via (TGV) technology, and to a method for improving electrical characteristics through more reliable copper (Cu) thin film deposition.

### DESCRIPTION OF THE RELATED ART

Through Glass Via (TGV) technology is playing an important role in the semiconductor and electronic packaging industries, and is drawing attention particularly noteworthy in radio frequency (RF) and 3D integrated circuit (3D IC) applications. TGV is a technology that forms a microscopic conductive via that penetrates a glass substrate to provide electrical connections between upper and lower circuits. Glass has low dielectric loss and high insulation resistance, so it is advantageous for RF signal transmission over conventional silicon (Si)-based substrates, and is also utilized in microelectromechanical systems (MEMS), optoelectronic systems, and high-speed data transmission applications. Due to these characteristics, the TGV technology is becoming an essential element in next-generation semiconductor and high-performance packaging solutions.

However, the existing TGV technology has several major technical problems. First, since glass is inherently an insulator, it is difficult to homogeneously deposit conductive materials into the vias formed therein. In particular, the bonding strength between glass and metal is low, so process optimization is necessary to ensure a reliable conductive path. In the existing process, an adhesive layer such as titanium (Ti) or chromium (Cr) is additionally formed for copper (Cu) deposition, but this method is complicated and increases manufacturing costs. In addition, it is difficult to homogeneously deposit metal on the inner wall of the TGV, and there is a high possibility that the electrical characteristics may deteriorate due to the uneven coating.

In order to solve these problems, the present invention proposes a technology for depositing a homogeneous copper thin film on the inside and surface of a TGV by applying an atomic sputtering epitaxy (ASE) process. When the ASE process is used, copper can be directly deposited even without a conventional adhesive layer, and a homogeneous conductive coating can be formed over the entire inner wall of a TGV. In addition, by controlling the surface roughness of the copper thin film at the nanometer level, which was not serious in bulk copper, electrical reliability can be ensured, and the resistance value can be lowered, thereby providing optimal performance in semiconductor packaging and RF applications. It is expected that through the technology of the present invention, the limitations of the conventional TGV process can be overcome and more reliable electrical connections can be implemented in next-generation electronic packaging and semiconductor ICs.

### [Related Art Documents]

### [Patent Document]

(PatentDocument001)KoreaPatentPublicaionNo.10-2024-0126851(published on August21, 2024)

### SUMMARY OF THE INVENTION

The present invention has been derived in order to solve the above-described problems, and an object of the present invention is to ensure the bonding reliability between glass and metal and to improve electrical performance through homogeneous thin film deposition by applying atomic sputtering epitaxy (ASE) technology.

The technical problems to be solved by the present invention are not limited to the above-mentioned technical problems, and other technical problems that are not mentioned may be clearly understood by a person having ordinary skill in the technical field to which the present invention pertains, from the description below.

A method of depositing a copper thin film inside a through glass via (TGV) using atomic layer sputtering epitaxy (ASE) according to the present invention,
is characterized in that the copper thin film is homogeneously deposited on the inside and surface of the TGV using an ASE process, and
the copper thin film is deposited so that the upper and lower electrical resistances of the TGV are less than or equal to 0.1 Ω.

In addition, the deposition is performed so that the thickness deviation of the copper thin film is less than or equal to ±5 nm over the entire inner wall of the TGV.

In addition, the copper thin film is formed so that the bonding strength between glass and copper is higher than or equal to 50 MPa.

In addition, the copper thin film formed through the ASE process is formed so that the root mean square (RMS) roughness is less than or equal to 4.5 nm.

In addition, the copper thin film formed through the ASE process is formed so that the thickness is less than or equal to 2,000 nm.

### BRIEF DESCRIPTION OF THE DRAWINGS

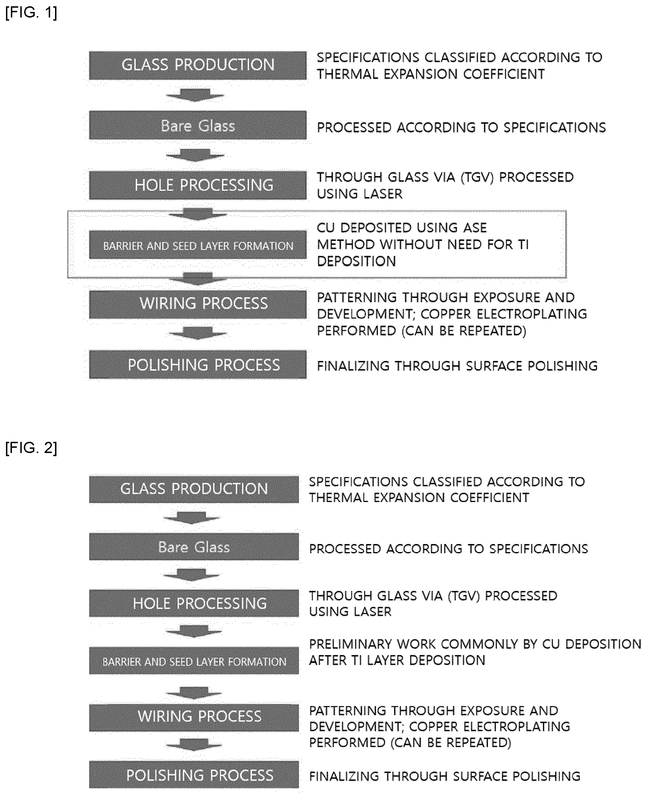

The above and other objects,features and advantages of the present inventtion will become more apparent to those of ordinary skill in the art by describing exemplary embodiments thereof in detail with reference to the accompanying drawings, in which: FIG. 1 shows a flowchart illustrating a glass semiconductor process including a method of depositing a copper thin film inside a through glass via (TGV) using atomic layer sputtering epitaxy (ASE) of the present invention;
FIG. 2 shows a flowchart illustrating a conventional glass semiconductor process;
FIG. 3 shows an image of Cu/TGV/Cu (right) in which copper is deposited on both side surfaces of a TGV (left) according to an embodiment of the present invention;
FIG. 4 shows an experimental photograph (right) in which conductivity is measured after depositing a copper thin film on both side surfaces of a TGV (Cu/Glass, left) according to an embodiment of the present invention, confirming that both side surfaces are connected with a conductor;
FIG. 5 shows an image observed with an optical microscope after depositing copper on both side surfaces of a TGV (left) according to an embodiment of the present invention;
FIG. 6 shows the result of confirming the thickness of a copper thin film (Cu/patterned glass, left) deposited on one side surface according to an embodiment of the present invention using an atomic force microscope (AFM);
FIG. 7 shows the result of confirming the surface roughness of a copper thin film (left) deposited on a TGV according to an embodiment of the present invention using an AFM;
FIG. 8 shows the result of observing a copper thin film deposited on a TGV according to an embodiment of the present invention using a scanning electron microscope (SEM) at different magnifications;
FIG. 9 shows the result of SEM measurement to confirm whether a cross-section of a TGV is coated with copper according to an embodiment of the present invention;
FIG. 10 shows an example of observing a cross-section by cutting a sample as shown in the left (a) and right (b) images to observe the inside of a hole according to an embodiment of the present invention;
FIG. 11 shows the result of observing a sample cut as in the left (a) image of FIG. 10 according to an embodiment of the present invention, using a SEM at different magnifications;
FIG. 12 shows the result of observing a sample cut as in the right (b) image of FIG. 10 according to an embodiment of the present invention, using a SEM;
FIG. 13 shows the result of measuring energy-dispersive X-ray spectroscopy (EDS) of a sample cut as in the left (a) image of FIG. 10 according to an embodiment of the present invention;
FIG. 14 shows the result of measuring EDS of a sample cut as in the left (a) image of FIG. 10 according to an embodiment of the present invention, according to the component distribution;
FIG. 15 shows the result of observing the inside of a via hole of a sample cut as in the right (b) image of FIG. 10 according to an embodiment of the present invention, using a SEM at different magnifications;
FIG. 16 shows diagrams illustrating (a) Cu deposited on one side surface of a TGV and (b) Cu deposited on both side surfaces according to an embodiment of the present invention;
FIG. 17 shows (a) a diagram of Cu deposited on both side surfaces of a TGV with a part in the middle where Cu is not deposited in order to examine whether a current flows through the copper deposited in the via hole according to an embodiment of the present invention, and (b) photograph showing surface resistance measurement;
FIG. 18 shows the surface resistance values measured for the ab, bc, cd, and da surfaces of FIG. 17 according to an embodiment of the present invention;
FIG. 19 shows the surface resistance measurement values of FIG. 17 according to an embodiment of the present invention;
FIG. 20 shows the result of observing the inside of a TGV without Cu deposition according to an embodiment of the present invention, using a SEM at different magnifications;
FIG. 21 shows the result of observing the inside of a TGV without Cu deposition according to a comparative example of the present invention, using a SEM;
FIG. 22 shows the result of observing the inside of a TGV hole with Cu deposition on both side surfaces according to an embodiment of the present invention, using a SEM;
FIG. 23 shows images comparing the inside of (a) a TGV hole without Cu deposition and (b) a TGV hole with Cu deposition on both side surfaces according to an embodiment of the present invention, using a SEM at a 10,000x magnification; and
FIG. 24 shows the result of observing surface roughness at various thicknesses according to an embodiment of the present invention, using an AFM.

### DETAILED DESCRIPTION OF THE EMBODIMENTS

The terms used herein will be briefly explained, and the present invention will be described in detail.

The terms used herein are selected as general terms that are currently widely used as much as possible while considering the functions in the present invention, but they may vary depending on the intention or precedent of those of ordinary skill in the art, the emergence of new technology, or the like. Therefore, the terms used in the present invention should be defined based on the meaning of the terms and the overall content of the present invention, rather than simply the names of the terms.

Throughout the present specification, when a part is said to "comprise" a certain element, unless otherwise specified, it means that other elements may be further included rather than excluding other elements.

Hereinafter, embodiments of the present invention are described in detail with reference to the attached drawings so that those skilled in the art can easily practice the present invention. However, the present invention may be implemented in various different forms and is not limited to the embodiments described herein.

Specific details, including the problems to be solved by the present invention, technical solutions, and effects of the invention, are included in the embodiments and drawings described below. The advantages and features of the present invention and methods for achieving them will become apparent with reference to the embodiments described in detail below together with the accompanying drawings.

Hereinafter, the present invention will be described in more details with reference to the attached drawings.

The present invention relates a method of homogeneously depositing a copperthin film on the inside and surface of a through glass via (TGV) using an atomic sputtering epitaxy (ASE) process.

As shown in FIG. 1, in the existing TGV process, copper (Cu) was commonly deposited using an adhesive layer such as Ti or Cr, but this method causes problems in that the process is complicated and manufacturing costs increase. In addition, even when there is an adhesive layer, it is difficult to form a homogeneous copper thin film over the entire inner wall of the TGV, which may result in a problem such as incomplete electrical connectivity or high resistance values.

In contrast, the present invention enables direct deposition of copper without an adhesive layer by applying the ASE process. The ASE process utilizes a highly controlled sputtering technology to enable deposition at atomic levels, thereby enabling the formation of a copper thin film on the inner wall and surface of the TGV with a homogeneous thickness.

Unlike the existing method, the ASE process of the present invention simplifies the process by allowing direct deposition of copper without an additional adhesive layer. The thickness and surface properties of the copper thin film can be precisely controlled to ensure a lower resistance value. Compared to the existing electroplating method, a homogeneous conductive path can be formed over the entire inner wall of the TGV, thereby improving electrical connectivity.

More specifically, as shown in FIG. 2, in the existing glass semiconductor process, a Ti adhesive layer (Barrier & Seed Layer) for copper (Cu) deposition is required, and the overall process is carried out as described below.

In glass production, a glass substrate is produced, and the specifications are adjusted according to the coefficient of thermal expansion.

In bare glass processing, the glass substrate is processed to according to the desired specifications.

In hole processing, a TGV structure is formed using laser processing or wet/dry etching.

In barrier and seed layer formation, after depositing a Ti layer, a preliminary work is required to form a seed layer for Cu deposition. Although the Ti layer serves to improve the adhesion of the copper thin film, additional processing steps are required and so the manufacturing costs increase.

In wiring process, patterning is performed through exposure (lithography) and development processes, and then a copper electroplating process is carried out. This process may be performed repeatedly.

In polishing process, surface polishing is finally performed to form a homogeneous surface.

The present invention provides a method of directly depositing Cu without a Ti adhesive layer by applying the ASE process, and as shown in FIG. 1, there is a difference in the formation of a barrier and a seed layer.

In the existing process, formation of a seed layer is required for Cu deposition after Ti layer deposition, but in the present invention, Cu may be directly deposited without a Ti layer by using the ASE process. In other words, since Ti deposition is not required, the process can be simplified, and the cost can be reduced.

In addition, the wiring process is carried out in the same way as the existing process, including exposure (lithography) and patterning, and copper electroplating is possible. Since the copper thin film deposited through the ASE process maintains homogeneity inside the TGV, high electrical connectivity can be achieved without forming an additional adhesive layer.

The present invention relates to a technology for homogeneously depositing a copper thin film on the inside and surface of a TGV using an ASE. In particular, the present invention aims to ensure excellent electrical characteristics in the fields of high-speed data transmission and radio frequency (RF) packaging by depositing the copper thin film so that the electrical resistance of the upper and lower portions of the TGV is less than or equal to 0.1 Ω (based on a glass thickness of 500 µm, a hole diameter of 95 µm, and a via hole depth-to-diameter aspect ratio of 1:5).

Conventional copper deposition methods (e.g., electroplating or physical vapor deposition (PVD)) may cause thickness imbalance and increased resistance in the inner wall of the TGV. However, the ASE process applied in the present invention is capable of controlling deposition at the atomic layer level, thereby ensuring more homogeneous copper thin film formation and lower resistance values.

When the ASE-based deposition method of the present invention is applied, a copper thin film can be homogeneously formed along the inner wall of the TGV, and the upper and lower portions of the TGV can be smoothly connected to maintain a low resistance value. Through this, compared to existing technologies, power loss can be reduced, signal transmission speed can be fast, and stable performance can be provided in semiconductor packaging and high-frequency applications.

In addition, the present invention indudes a method of forming a homogeneous copperthin film over the entire area of the inner wall of a TGV. In the conventional copper deposition methods (e.g., electroplating and PVD), a large thickness deviation occurs at the upper portion and the lower portion of the TGV or at a specific part of the inner wall, and so it is difficult to ensure a homogeneous conductive path.

Since the ASE process of the present invention enables precise deposition control at the atomic layer level, the thickness deviation of the copper thin film over the entire inner wall of the TGV can be maintained to ±5 nm or less. Through this, the homogeneity of electrical connections is improved, and the deviation in resistance values is reduced, thereby improving overall reliability.

In addition, homogeneity can be ensured by measuring thickness deviation through atomic force microscopy (AFM) and scanning electron microscopy (SEM) analyses. Through these, it can be verified that the copper thin film applied with the ASE process is precisely formed inside the TGV structure, and high reliability can be maintained even in high-speed signal transmission applications.

In the conventional method, the thickness deviation of the copper thin film often occurred by ±10 nm or more depending on the location of the inner wall of the TGV. The electric field is unevenly distributed depending on the shape of the inner wall of the TGV, and in particular, the current density is high at the upper portion of the TGV and low at the lower portion, and therefore, homogeneous deposition is difficult. Furthermore, since the deposition directionality is strong in PVD deposition, and the deposition speed decreases as it goes toward the bottom of the TGV. Due to this, it is difficult to ensure a homogeneous thickness over the entire inner surface of the TGV.

On the other hand, the ASE method of the present invention is optimized to deposit copper atoms with high homogeneity by controlling plasma energy. In other words, by applying the RF plasma control technology that maintains a constant deposition rate, it is possible to control the thickness deviation to be less than or equal to ± 5 nm over the entire inner wall of the TGV. It was confirmed that the same thickness was maintained over the entire inner wall even when the depth of the TGV was 400 µm to 700 µm.

Through this homogeneous thin film formation, the current flow through the TGV is maintained constant, and therefore, a highly reliable conductive path can be provided.

In addition, in the existing TGV process, exfoliation due to the low bonding strength between copper and glass is frequently reported. In particular, when the bonding strength is weak, reliability may be reduced in high-temperature and high-humidity environments.

In the present invention, the ASE process is utilized so that a copper thin film may be directly deposited without an additional adhesive layer (Ti, Cr, etc.). The high deposition energy of the ASE process allows copper atoms to strongly bond to the glass surface, and the bonding strength higher than or equal to 50 MPa may be maintained.

Through this, unlike the conventional method in which Ti or Cr needs to be used as an adhesive layer, a copper thin film may be formed without a Ti or Cr adhesive layer in the ASE method by controlling the plasma energy so that the copper atoms can directly bond with the glass surface. In the early stage of the ASE process, the glass surface undergoes plasma activation so that the copper atoms may bond more strongly. Through this process, a bonding strength higher than or equal to 50 MPa may be ensured between the glass and copper. Therefore, the TGV can maintain reliability even in high-temperature and high-humidity environments and is suitable for high-performance semiconductor packaging.

In addition, copper thin films formed by conventional electroplating or PVD processes have relatively high surface roughness (root mean square (RMS) roughness), which may result in electrical characteristics deterioration and signal transmission loss.

When the ASE process of the present invention is applied, the surface roughness of a copper thin film may be precisely controlled, and the RMS roughness may be maintained in a range of 4.5 nm or less. More preferably, it may be maintained within a range of 3.0 to 4.5 nm.

In the existing PVD method, a roughness of 5 to 10 nm or more may be formed, which is likely to increase RF signal transmission loss. In the ASE method, the deposition speed may be precisely controlled so that a stable surface roughness within a range of 3.0 to 4.5 nm is provided.

Low surface roughness reduces electrical contact resistance and contributes to minimizing reflection loss during high-speed signal transmission. In addition, since a homogeneous thin film may be formed through the ASE process, excellent signal transmission characteristics can be provided in RF and high-frequency applications.

In addition, the present invention aims to maintain the thickness of the copperthin film deposited on the inner wall and surface of a TGV to 1,100 nm or more by using the ASE process.

In the conventional method, there is a possibility that the thickness is uneven or too thin, which deteriorates the electrical connectivity. The ASE-based copper deposition method of the present invention is designed to ensure sufficient conductivity while maintaining a homogeneous thickness.

When the ASE process of the present invention is applied, the thickness of the copper thin film may be maintained at 1,100 nm or more, and through this, electrical connectivity is improved. When sufficient thickness is not ensured in the inner wall of a TGV, the current density may not be homogeneous during signal transmission, which may deteriorate reliability, and when the copper thin film thickness is maintained at 1,100 nm or more, the current carrying capacity increases, and thus the signal transmission characteristics are improved. Since the ASE method can precisely control the thickness, it is possible to ensure a homogeneous conductive path compared to the existing method.

Through this, the copper thin film inside the TGV can form a highly reliable conductive path and exhibit excellent performance in high-speed data transmission and RF signal transmission.

The ASE-based copperthin film deposition process of the present invention is a method of depositing copper atoms in atomic layer units under a highly controlled plasma state. The following process variables are optimized during the deposition process.

### ① Process temperature and initial pressure

The temperature of the deposition environment is controlled at 170 °C, the initial vacuum is lower than or equal to 1.5×10⁻⁶ Torr, and the deposition is performed in an argon (Ar) atmosphere, and at this time, the pressure should be maintained at 5.4×10⁻³ Torr.

### ② Plasma pressure control

The plasma process is carried out in an Ar atmosphere, and the pressure is maintained constant at a 5.4×10⁻³ Torr to stabilize the process atmosphere.

Under these conditions, copper is homogeneously formed over the entire inner wall of the TGV during deposition.

In the electroplating method, copper is deposited through a chemical reaction in an electrolyte solution, and thickness imbalance may occur due to the difference in current density on the inner wall of the TGV. Since the ASE method deposits at atomic units, homogeneous deposition is possible even inside the TGV, and the possibility of impurity mixing is low. Through the application of this optimized ASE process, the electrical resistance of the upper and lower portions of the TGV can be maintained at 0.1 Ω or lower, and homogeneous conductivity suitable for high-speed signal transmission is ensured.

Hereinafter, the present invention will be described in more detail bycomparingoomparative examples manufactured by conventional methods with examples and by referring to experimental examples. The objects, features, and advantages of the present invention will be easily understood through the examples described below. The present invention is not limited to the examples described herein and may be embodied in other forms. The examples introduced herein are provided so that the idea of the present invention may be sufficiently conveyed to those skilled in the art to which the present invention pertains. Therefore, the present invention should not be limited by the examples described below.

### Example 1: Deposition of copper thin films in TGV using ASE process

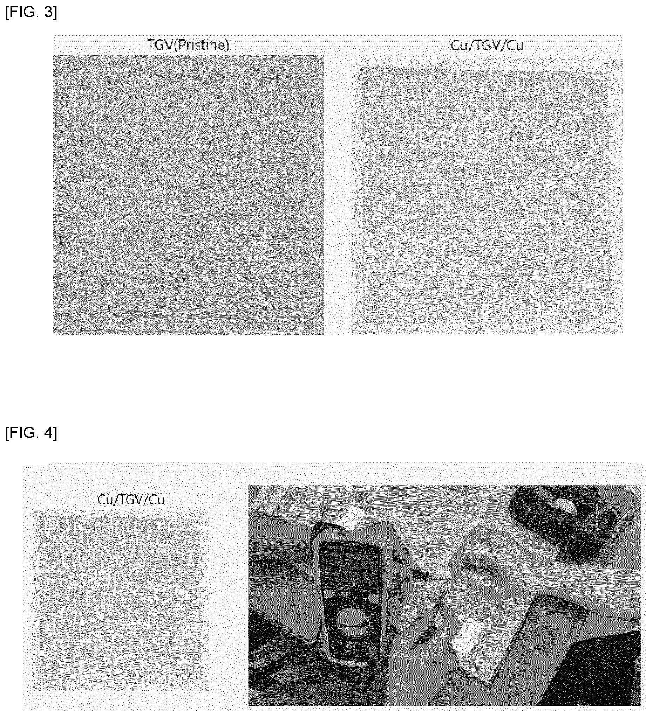

In this example, a method of depositing a homogeneous copper thin film on the inner wall and surface of a TGV using the ASE process was applied, and the results are shown in FIG. 3. Through this, the homogeneous thickness formation and the electrical characteristics of the copper thin film were evaluated in the experimental example described below.
- Substrate (material): Asahi Glass (500 µm thick)
- TGV formation method: TGV processing using laser drilling
- TGV diameter (hole size): About 94 µm
- TGV depth (hole depth): 500 µm
- Copper thin film deposition method: ASE process applied
- Deposition conditions:
- Plasma gas: Ar
- Process temperature: 170 °C
- Deposition pressure: 5.4×10⁻³ Torr

### Experimental Example 1: Evaluation of electrical characteristics

As shown in FIG. 4, in Experimental Example 1, after depositing a copper thin film on both side surfaces of the TGV, the conductivity was measured to confirm that both side surfaces were connected as conductors.

The experimental conditions are as follows.
- A 4-probe resistance measurement method was applied.
- Electrical resistance measurement

The electrical resistance was evaluated by connecting the upper portion and the lower portion of the TGV.

It was confirmed that, compared to the existing electroplating method, the resistance value was reduced by more than 30% when the ASE process was applied.

### Experimental Example 2: Optical microscope analysis

After forming a TGV on a glass substrate (Asahi Glass, 500 µm thick) using laser drilling, a copper thin film was deposited on the inner wall of the TGV using the ASE process. After applying the ASE process, the diameter and shape of the TGV were analyzed using an optical microscope, and the effect of the ASE process on the homogeneity and size maintenance of the TGV pattern was evaluated.

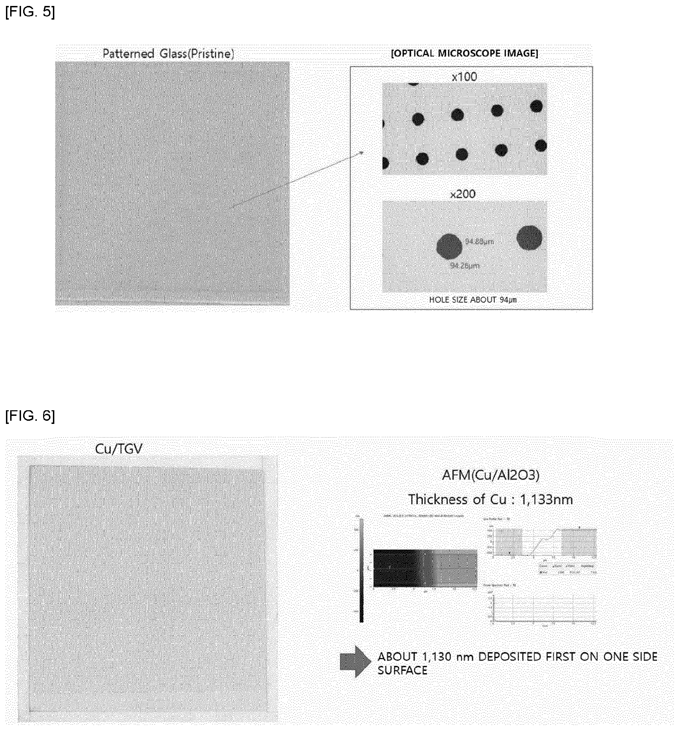

As shown in FIG. 5, the results of the optical microscope analysis confirmed that the diameter (94.88 µm, 94.26 µm) of the TGV was maintained even after the application of the ASE process, and the copper thin film was homogeneously formed over the entire inner wall. In addition, it was verified that the TGV pattern was maintained without deformation through the ASE process, and the homogeneity of the copper thin film deposition was ensured, and thus the reliability of the conductive path was improved.

### Experimental Example 3: Measurement of copperthin film deposition thickness

A copper (Cu) thin film was deposited on a glass substrate by applying the ASE process, and the thickness of the deposited copper thin film was measured using AFM. The measurement target was a sample with a Cu/Al₂O₃ structure, and the change in the thickness of the copper thin film on one side surface was analyzed to evaluate whether homogeneous deposition was achieved through the ASE process.

As shown in FIG. 6, the AFM analysis results showed that the measured average thickness of the copper thin film deposited through the ASE process was to be 1,133 nm, and it was confirmed that a homogeneous deposition of approximately 1,130 nm was achieved on one side surface. These results demonstrate that compared to the conventional deposition method, the ASE process can ensure sufficient thickness while maintaining high homogeneity, and suggest that it can provide reliable electrical characteristics through the formation of a homogeneous conductive path.

### Experimental Example 4:Analysis of surface roughness (RMSroughness)of copperthin film

After depositing a copper thin film on the inner wall and surface of a TGV by applying the ASE process, the surface roughness (RMS roughness) of the thin film was measured using AFM. The analysis target was a copper thin film deposited at a specific location on the inner wall of the TGV, and the measurement data was collected within a 10 µm² area.

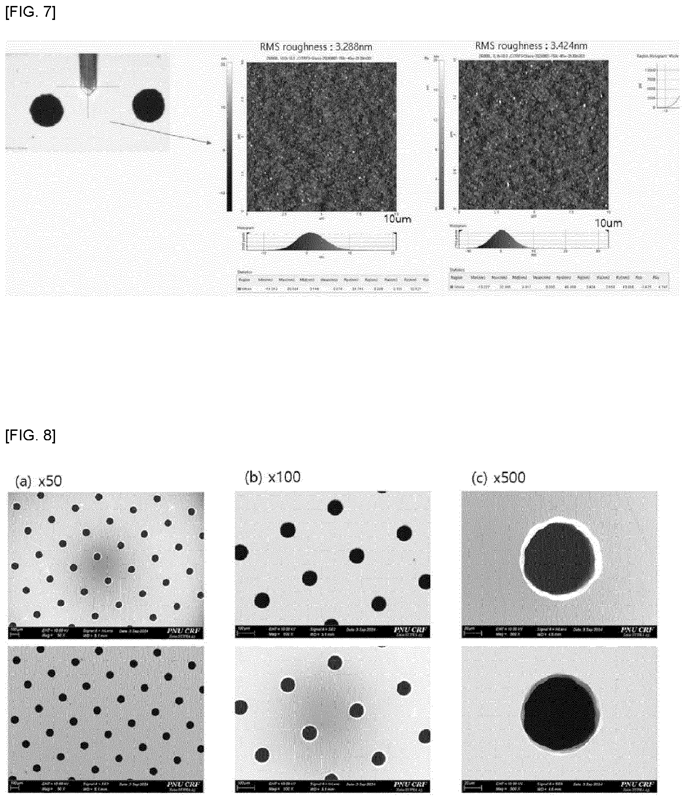

As shown in FIG. 7, the results of the AFM analysis showed that the measured RMS roughness of the copper thin film formed by applying the ASE process was 3.288 nm and 3.424 nm, indicating that a more homogeneous surface was provided compared to the conventional electroplating method. This low surface roughness may contribute to reducing the electrical contact resistance and improving the RF signal transmission characteristics, and it was demonstrated that the ASE process enables the formation of a homogeneous thin film on the inner wall of the TGV.

In addition, copper thin films having different thicknesses (20 nm (b), 100 nm (c), 1,100 nm (d)) were deposited on glass substrates (Asahi Glass) using the ASE process, and then AFM analysis was performed. The RMS roughness value was measured for each sample to quantitatively evaluate the surface roughness, and the change in roughness according to the change in copper thin film thickness was analyzed. Through this, it was confirmed how homogeneously the copper thin films were deposited by applying the ASE process as the thickness increased.

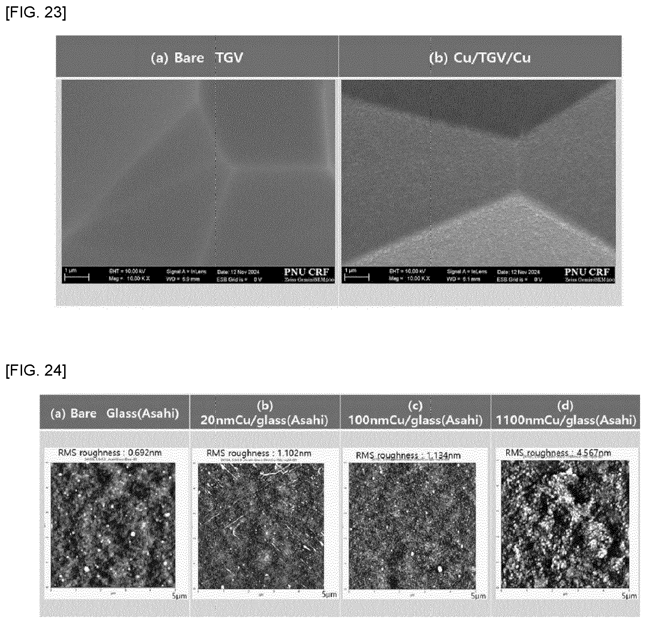

As shown in FIG. 24, the AFM analysis results showed that the RMS roughness of the bare glass substrate was 0.692 nm, and as the copper thin film thickness increased to 20 nm and 100 nm, the roughness slightly increased to 1.102 nm and 1.134 nm, respectively, but the thin films still maintained a low level of surface roughness. On the other hand, the RMS roughness value increased to 4.567 nm for the copper thin film with a thickness of 1,100 nm, confirming that the surface roughness also increased as the film thickness increased. These results suggest that the ASE process enables very homogeneous deposition in copper thin films having a small thickness, but there is a possibility that the surface roughness may increase due to grain growth when the thickness increases. Through these results, it was confirmed that the copper thin film formed by applying the ASE process maintains excellent surface homogeneity, but it is necessary to optimize the deposition conditions above a certain thickness.

### Experimental Example 5: SEM analysis

After depositing a copper thin film on the inner wall and surface of a TGV using the ASE process, a SEM analysis was performed. The upper portion and the cross-section of the TGV structure were observed at various magnifications (x50, x100, x500) to evaluate the homogeneity, thickness deviation, and deposition state of the copper thin film formed through the ASE process.

As shown in FIG. 8, the SEM analysis results confirmed that a homogeneous copper thin film was formed over the entire inner wall of the TGV through the ASE process and that a constant conductive path was ensured without thickness deviation. In particular, the cross-sectional image observed at x500 magnification visually demonstrated that the copper thin film on the inner wall of the TGV was homogeneously deposited, confirming that the ASE process provides superior thin film homogeneity compared to the conventional method.

### Experimental Example 6:Confirmation of cross-sectional copperthin film deposition in TGV

A copper thin film was deposited on the inner wall of a TGV using the ASE process, and then a SEM analysis was performed. In the experiment, the TGV cross-section was observed at various magnifications (×157, ×500) to confirm whether the copper thin film was homogeneously deposited over the entire inner wall through the ASE process, and the coating thickness and shape at specific points on the cross-section were measured.

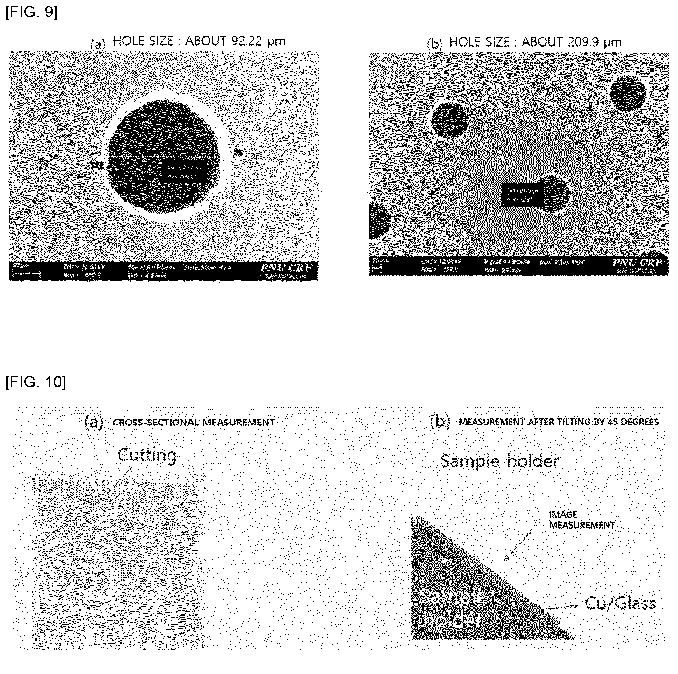

As shown in FIG. 9, the SEM analysis results confirmed that the copper thin film deposited through the ASE process was homogeneously coated over the entire inner wall of the TGV and formed with a constant thickness even on specific cross-sections. The measured cross-sectional size (92.22 µm, 200.9 µm) and the homogeneity of the analyzed copper thin film demonstrated that the ASE process provides higher coating precision than the conventional method, suggesting that it can improve the reliability of the conductive path in the TGV.

### Experimental Example 7: Analysis of cross-sectional copper thin film in TGV

As shown in FIG. 10, a copper thin film was deposited on the inner wall of a TGV by applying the ASE process, and then the sample was cut at a specific angle to evaluate the coating homogeneity of the deposited copper thin film. The cut cross-section was analyzed using SEM to confirm whether the copper thin film was homogeneously deposited over the entire inner wall of the TGV, and the thickness deviation and deposition state were evaluated.

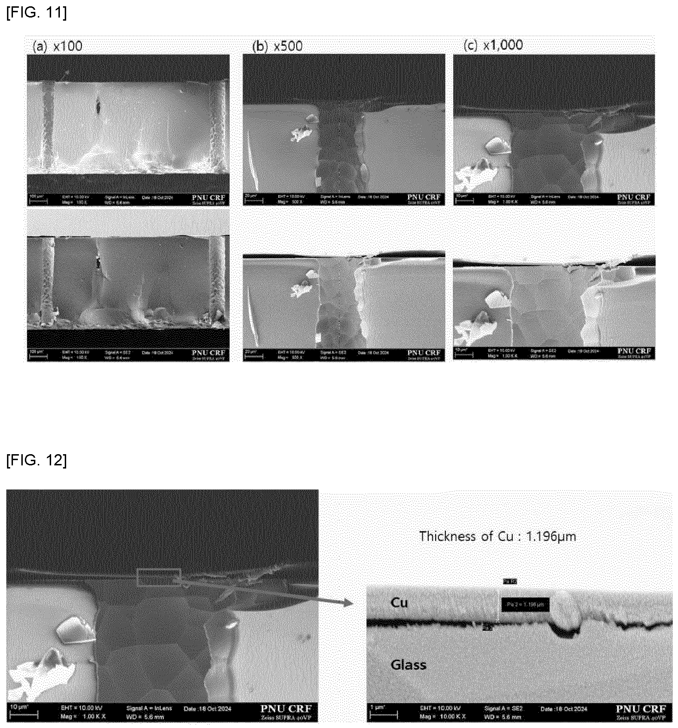

After depositing a copper thin film on the inner wall of a TGV by applying the ASE process, SEM observation was performed to analyze the structural characteristics and bonding form of the deposited thin film. As shown in FIG. 11, the sample was cut at a specific angle to expose the cross-section. Then, a SEM analysis was performed at various magnifications (×100, ×500, ×1000) to evaluate the homogeneity of the copper thin film, the formation of a conductive path, and the bonding state within the cross-section.

As shown in FIG. 11, the SEM analysis results confirmed that the copper thin film deposited through the ASE process was homogeneously formed over the entire inner wall of the TGV and that a clear conductive path was ensured. In addition, cross-sectional observation provided evidence suggesting that the copper thin film formed a Cu/TGV/Cu structure across the TGV rather than simply coating the inner wall. The fragments of the cut sample generated during the experiment, which were generated during the measurement for analysis, demonstrated that the copper thin film formed through the ASE process had excellent bonding reliability within the TGV structure.

In addition, as shown in FIG. 12, the cross-section was photographed at a high magnification (×1000) to clearly confirm an interface between the copper thin film and the glass substrate and to precisely measure the thin film thickness. The SEM analysis results confirmed that the copper thin film deposited through the ASE process was homogeneously formed with a thickness of 1.196 µm. The results verified that the copper thin film was stably bonded to the glass substrate, and the film thickness deviation was minimized so that a homogeneous conductive path can be provided. These results suggest that the ASE process guarantees superior film homogeneity compared to the conventional method and can provide high reliability in TGV-based electronic packaging technology.

### Experimental Example 8: Energy dispersive spectroscopy (EDS) analysis

After depositing a copper thin film on the inner wall of a TGV using the ASE process, an EDS analysis was performed to evaluate the elemental composition. The distribution of elements inside the TGV was visually confirmed through the EDS analysis combined with SEM, and the elemental composition and relative distributions of copper (Cu), silicon (Si), and oxygen (O) were compared. The blue area in the CuK image represents the copper thin film deposited on the inner wall of the TGV, and this was used to evaluate the homogeneity of copper deposition.

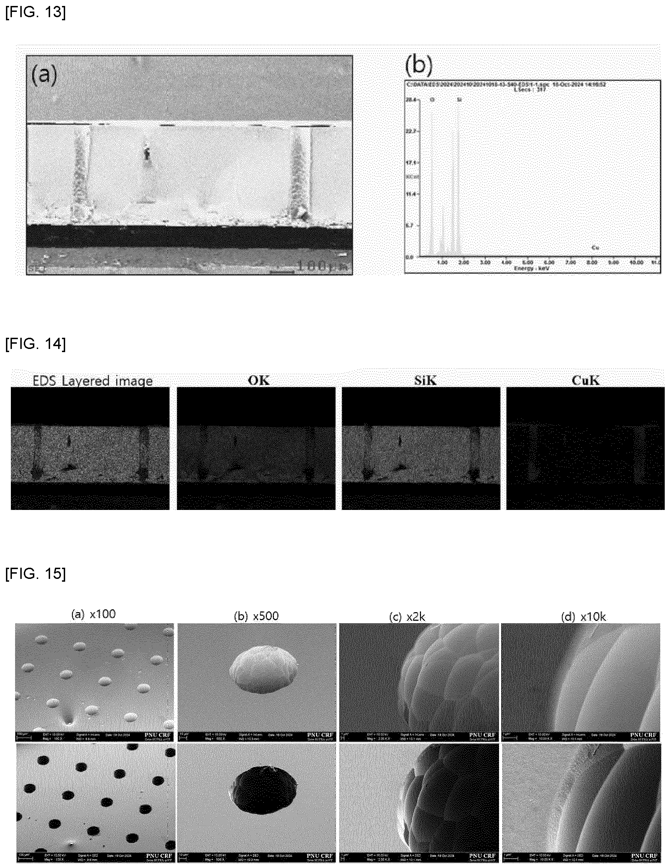

As shown in FIG. 13A, the EDS analysis results confirmed that copper was homogeneously deposited on the inner wall of the TGV through the ASE process and that a constant distribution was maintained even inside the hole. As a result of the component analysis, as shown in FIG. 13B, a copper (Cu) signal was clearly detected, verifying that the ASE process is a deposition process that provides higher homogeneity compared to the conventional method. In addition, as shown in FIG. 14, the blue area in the CuK image clearly showed the copper thin film formed inside the TGV, suggesting that copper deposition was successfully achieved by applying the ASE process.

**[Table 1]**

| **Element** | **Wt%** | **At%** |
|---|---|---|
| **OK** | 48.84 | 65.21 |
| **SiK** | 41.43 | 31.51 |
| **CuK** | 09.74 | 03.27 |
| **Matrix** | Correction | ZAF |

### Experimental Example 9: Homogeneity and surface analysis

After depositing a copper thin film on the inner wall of a TGV using the ASE process, the sample tilted at an angle of 45 degrees in FIG. 10B was analyzed using SEM. SEM images were obtained at various magnifications to evaluate whether the copper thin film was homogeneously deposited inside the TGV and how smoothly the surface was formed. In addition, it was confirmed how homogeneously the copper thin film was formed on the glass surface.

As shown in FIG. 15, the SEM analysis results confirmed that the copper thin film was smoothly deposited inside the TGV through the ASE process, and that the glass surface was coated very homogeneously. In particular, the high-magnification analysis demonstrated that the copper thin film was smoothly deposited not only on the substrate surface but also inside the TGV, and that the reliability of the conductive path was improved through the uniformly thin film formation. These results demonstrate that the ASE process is effective in forming a more precise and homogeneous film compared to the conventional method.

### Experimental Example 10: Comparison of sheet resistance and resistivity

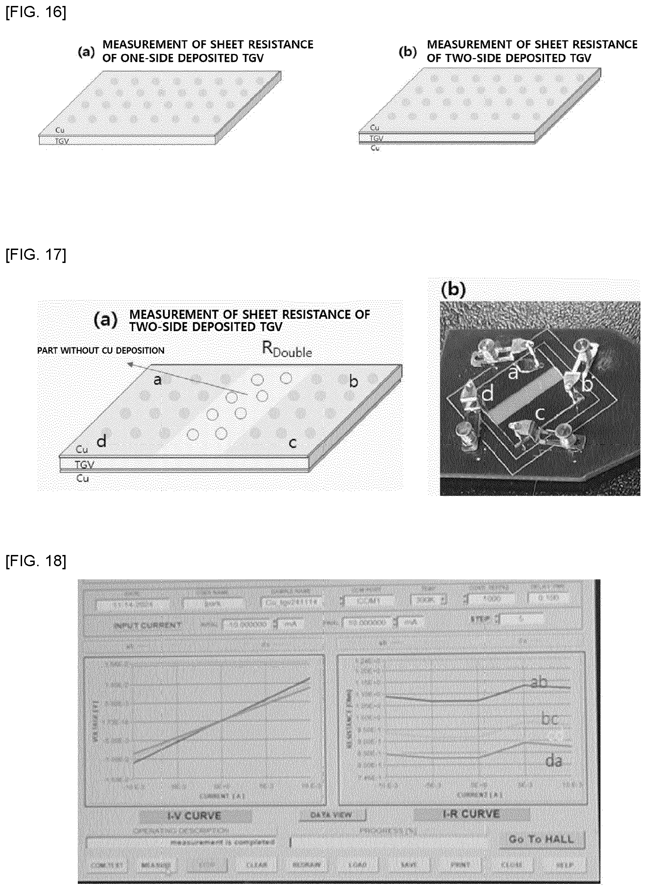

After depositing a copper thin film on the inner wall of a TGV by applying the ASE process, sheet resistance and resistivity measurement experiments were performed to compare the electrical characteristics of one-side deposition (a) and double-side deposition (b), as shown in FIG. 16. The conductive path inside the TGV was analyzed using the 4-point probe measurement method, and the resistance applied to both ends was measured to calculate the values using the method for calculating resistance in parallel.

**[Table 2]**

| Experimental conditions | Sheet resistance value (Ω/sq) |
|---|---|
| Applying ASE process (depositing 1,100 nm copper) | 0.0864 Ω/sq |
| Applying existing electroplating method (depositing 1,100 nm copper) | 0.12 Ω/sq |

The measurement results confirmed that the sheet resistance of the one-side deposited TGV was 0.02390 Ω/sq, and that of the double-side deposited TGV was 0.01099 Ω/sq, demonstrating that double-side deposition may further lower the electrical resistance. In addition, the measured resistivity value was also lower in double-side deposition (2.417×10⁻⁶ Ω·cm) than in one-side deposition (2.639×10⁻⁶ Ω·cm), confirming that homogeneous copper deposition was achieved inside the TGV through the ASE process and that double-side deposition is effective in improving electrical performance.

### Experimental Example 11: Electrical resistance measurement

To evaluate the electrical characteristics of the Cu/TGV/Cu structure formed through the ASE process, the resistance was measured using the 4-point probe method. A current was applied to each area (a, b, c, d) of the sample to obtain and analyze an I-V curve, and the sheet resistance and resistivity were calculated based on this. In addition, the measurement values were compared to confirm whether a conductive path of the TGV structure formed by applying the ASE process was homogeneously formed.

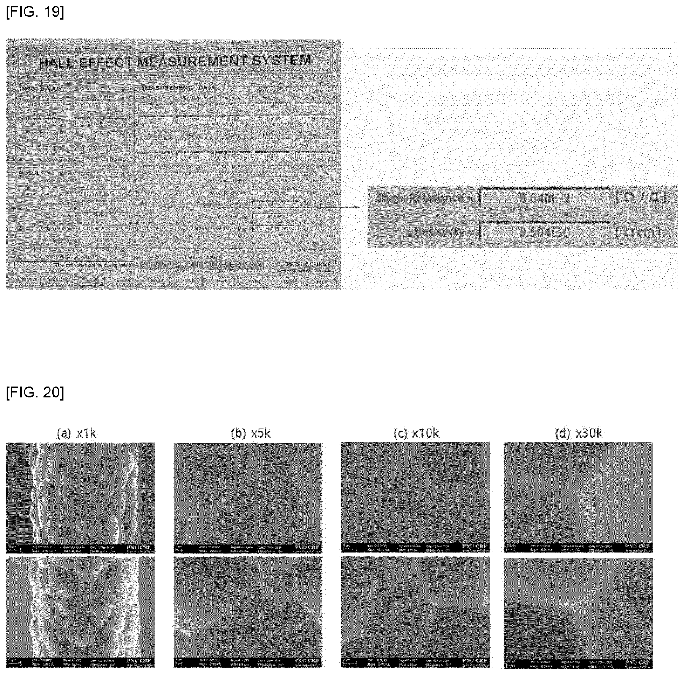

As shown in FIGS. 18 and 19, the measurement results showed that the sheet resistance of the Cu/TGV/Cu structure was 0.0864 Ω/sq and the resistivity was 9.504 × 10⁻⁶ Ω cm, confirming that a homogeneous conductive path was ensured through the ASE process. Linear current-voltage characteristics were also confirmed in the I-V curve analysis, which means that the ASE process provides lower resistance and homogeneous electrical characteristics compared to the conventional method. These results suggest that the TGV structure formed by applying the ASE process can have high reliability in the field of electronic packaging that requires high-speed signal transmission and power efficiency.

**[Table 3]**

| Item | Measurement value |
|---|---|
| Sheet Resistance [Ω/sq] | 0.0864 |
| Resistivity [Ω.cm] | 9.504*10⁻⁶ |

### Experimental Example 12: Cross-sectional SEM analysis

In order to analyze the TGV structure before applying the ASE process, the inside of a bare TGV without copper deposition was observed using SEM. Cross-sectional images were obtained at various magnifications (×1,000, ×5,000, ×10,000, ×30,000), and the crystal structure and surface characteristics inside the substrate were comparatively analyzed. Through this, the conditions of the TGV inner wall before and after copper deposition were compared, and the effect of the ASE process on the TGV inner wall structure was evaluated.

As shown in FIG. 20, the SEM analysis results clearly showed a rough surface and a polygonal grain structure inside the bare TGV without copper deposition, confirming that the inner wall of the TGV had a relatively bumpy and ununiform structure. These characteristics may be comparatively analyzed with the changes in surface roughness (RMS roughness) and grain structure after copper deposition, and it is expected that the inner wall may be more homogeneous and smoother by applying the ASE process. Through this experiment, the process improvement effect on the inner wall of the TGV may be verified in comparison with the copper thin film deposition conditions after the ASE process.

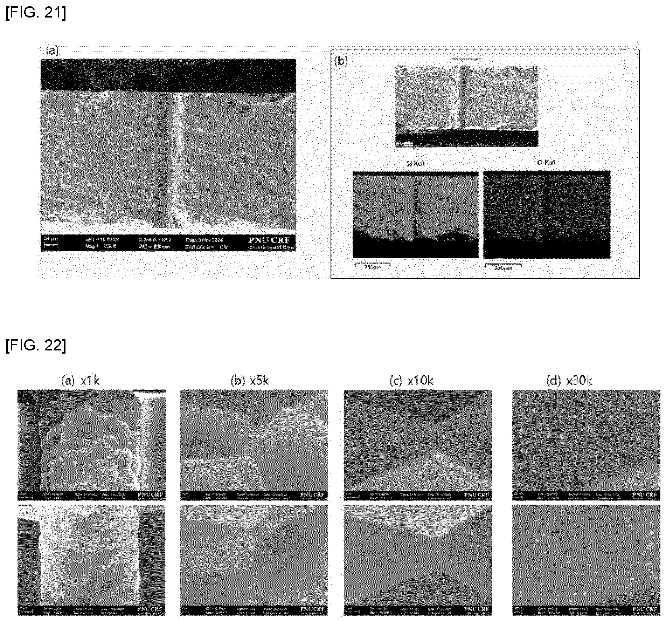

In addition, as shown in FIG. 21A, the SEM analysis results confirmed that the surface of the inner wall of the bare TGV had irregular and uneven grain structure and relatively high surface roughness. In addition, as shown in FIG. 21B, the EDS analysis results showed that the distribution of silicon and oxygen, which are the main components of the TGV inner wall, was homogeneous, and it is expected that the surface properties of the inner wall may be improved when the copper thin film is homogeneously deposited through the ASE process. Through this experiment, the effect of copper thin film deposition after applying the ASE process was compared, and the possibility of improving the electrical and physical properties of the TGV inner wall was confirmed.

In addition, as shown in FIG. 22, the inside of the TGV hole where copper was deposited on both side surfaces was observed using SEM. It was confirmed that a homogeneous copper thin film was formed on the inner wall of the TGV where copper was deposited on both side surfaces through the ASE process, and that the surface had a softer and smoother grain structure than that of the existing bare TGV.

In addition, as shown in FIG. 23, the inside of the hole was compared by SEM with a 10,000x magnification image between the bare TGV and the TGV with copper deposited on both side surface. It was confirmed that the inner wall of the bare TGV showed a rough and uneven polygonal crystal structure, while a fine and homogeneous copper thin film was deposited in the Cu/TGV/Cu structure.

By the above-described technical solutions, the present invention may effectively solve the problems of the existing TGV process, such as lack of bonding reliability between metal and glass, unevenness of inner wall coating, and deterioration of electrical characteristics.

In addition, the present invention can directly deposit copper by applying the ASE process even without an adhesive layer, thereby simplifying the process and reducing the manufacturing costs.

In addition, the present invention can ensure high electrical reliability and low resistance values by precisely controlling surface roughness at the nanometer (nm) level and provide stable conductivity between upper and lower electrodes.

In addition, the present invention can be utilized as a process that minimizes signal loss in the next-generation semiconductor and electronic packaging fields such as radio frequency (RF), high-density integrated circuit (HDI), and 3D stacked packaging (3D IC) and is also suitable for mass production.

As such, it will be understood by those skilled in the art that the above-described technical features of the present invention can be implemented in other specific forms without changing the technical idea or essential features of the present invention.

Therefore, the above-described embodiments should be understood as illustrative and not restrictive in all respects, and the scope of the present invention is indicated by the claims described below rather than the detailed description above, and all changes or modifications derived from the meaning and scope of the claims and their equivalent concepts should be construed as being included in the scope of the present invention.

## Claims

1. A method of depositing a copper thin film inside a through glass via (TGV) using atomic layer sputtering epitaxy (ASE), wherein the copper thin film is homogeneously deposited on the inside and surface of the TGV using an ASE process, and the copper thin film is deposited so that the upper and lower electrical resistances of the TGV are less than or equal to 0.1 Ω.

2. The method depositing a copper thin film inside a TGV using ASE according to claim 1, wherein the deposition is performed so that the thickness deviation of the copper thin film is less than or equal to ±5 nm over the entire inner wall of the TGV.

3. The method depositing a copper thin film inside a TGV using ASE according to claim 1, wherein the copper thin film is formed so that the bonding strength between glass and copper is higher than or equal to 50 MPa.

4. The method depositing a copper thin film inside a TGV using ASE according to claim 1, wherein the copper thin film formed through the ASE process is formed so that the root mean square (RMS) roughness is less than or equal to 4.5 nm.

5. The method depositing a copper thin film inside a TGV using ASE according to claim 1, wherein the copper thin film formed through the ASE process is formed so that the thickness is less than or equal to 2,000 nm.
